Europäisches Patentamt

European Patent Office

Office européen des brevets

(19)

(11) Publication number: **0 288 977**

**A1**

## (12) EUROPEAN PATENT APPLICATION

(21) Application number: **88106675.7**

(22) Date of filing: **26.04.88**

(51) Int. Cl.⁴: **G01R 19/165**

(30) Priority: **28.04.87 JP 107009/87**
**14.03.88 JP 59653/88**
**23.03.88 JP 70296/88**

(43) Date of publication of application:
**02.11.88 Bulletin 88/44**

(84) Designated Contracting States:
**DE FR GB IT NL**

(71) Applicant: **CANON KABUSHIKI KAISHA**
**30-2, 3-chome, Shimomaruko**
**Ohta-ku Tokyo(JP)**

(72) Inventor: **Mita, Rikitaro**
**3-7-1, Tsuchihashi Miyamae-ku**
**Kawasaki-shi Kanagawa-ken(JP)**

(74) Representative: **Pellmann, Hans-Bernd,**
**Dipl.-Ing. et al**
**Patentanwaltsbüro**
**Tiedtke-Bühling-Kinne-Grupe-Pellmann**
**Grams-Struif-Winter-Roth Bavariaring 4**
**D-8000 München 2(DE)**

(54) **Current comparison circuit.**

(57) A current comparison circuit for comparing the value of an input current with a reference current value includes a constant current source which is arranged to produce a constant current of the reference current value and is connected to an input terminal to which the input current is allowed to flow, and a pair of PNP and NPN transistors which are arranged to have a constant voltage applied to their bases and to have their emitters interconnected. The emitters of the pair of PNP and NPN transistors are connected to a node between the input terminal and the constant current source.

FIG.2

EP 0 288 977 A1

## CURRENT COMPARISON CIRCUIT

### Background of the Invention:

#### Field of the Invention:

This invention relates to an electric current comparison circuit and more particularly to a circuit arranged to determine the magnitude of an electric current flowing in or out of the circuit relative to a given value.

#### Description of the Related Art:

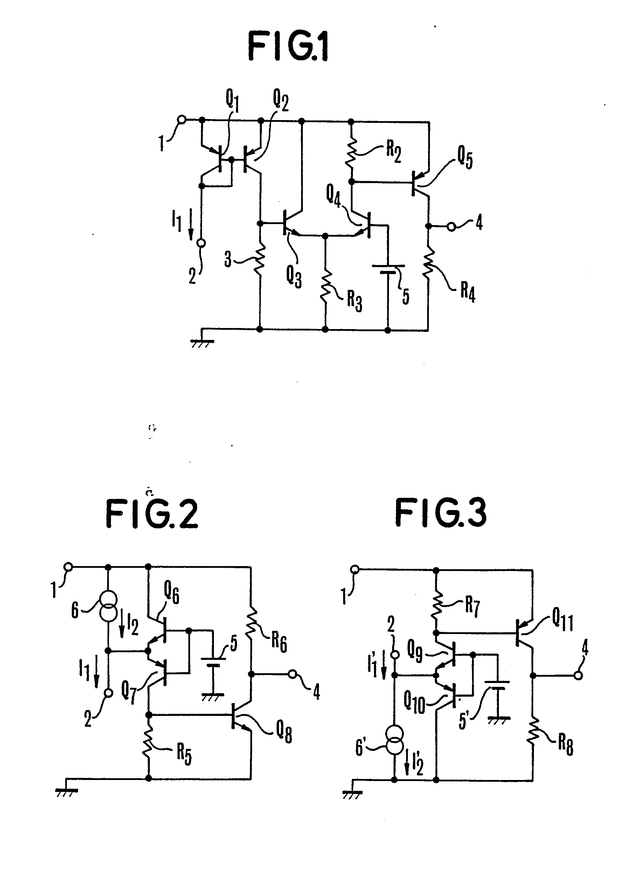

Fig. 1 of the accompanying drawings shows the conventional current comparison circuit, which has been arranged first to convert an input current into a voltage and then to take the voltage into a voltage comparison circuit.

Referring to Fig. 1, when the input current I1 flows out from an input terminal 2, the current I1 is about equal to the collector current of a transistor Q1. Since transistors Q1 and Q2 form a current mirror, the collector current Ic2 of the transistor Q2 becomes about equal to the current I1. Therefore, with the resistance value of a resistor 3 assumed to be R1, a voltage obtained at the resistor 3 becomes Ic2•R1. Transistors Q3 to Q5 and resistors R2 and R3 form an ordinary voltage comparator. The voltage comparator compares the voltage obtained at the resistor 3 with a reference voltage produced from a constant voltage source 5 and produces a discrimination signal either at a high or low level from an output terminal 4.

In order to prevent an error in converting the input current into a voltage, the comparison circuit of this kind requires a very severe degree of precision for the resistance value R1 of the resistor 3. However, in cases where the circuit of this kind is to be arranged using an IC, the absolute precision of the resistor to be used within the IC is normally ± 20 to 30% at the most while the temperature coefficient thereof is high and is about 2,000 ppm/°C. Therefore, the use of an IC for the circuit results in a large error due to not only the precision but also its temperature characteristic.

It is conceivable to solve this problem by some method of offsetting the above stated error relative to the constant voltage source 5. Such a method, however, inevitably necessitates a complex circuit arrangement.

### Summary of the Invention:

One aspect of the application is the provision of a comparison circuit for comparing an input current value obtained at an input terminal with a reference current value with the circuit arranged to have a constant current source which forms the reference current connected to the input terminal; to connect an NPN or PNP transistor in parallel to the constant current source; to connect a PNP or NPN transistor in series to the first transistor; and to interconnect the bases of these two transistors.

Another aspect of the application is the provision of a comparison circuit, wherein the current value of the above stated constant current source can be set at a desired value by selecting a desired resistance value.

A further aspect of the application is the provision of a stabilizing circuit which is arranged to stabilize the comparing operation of the above stated comparison circuit.

The above and other aspects of the invention will become apparent from the following detailed description of embodiments thereof taken in connection with the accompanying drawings.

### Brief Description of the Drawings:

Fig. 1 is a circuit diagram showing the conventional current comparison circuit. Fig. 2 is a circuit diagram showing a current comparison circuit arranged according to this invention as an embodiment thereof. Figs. 3, 4 and 5 are circuit diagrams showing current comparison circuits arranged also according to this invention as other embodiments thereof.

### Detailed Description of the Preferred Embodiments:

Fig. 2 shows in a circuit diagram an embodiment of this invention. The illustration includes a power supply terminal 1; an input terminal 2; an output terminal 4; a constant voltage source 5; a constant current source 6; NPN transistors Q6 and Q8; a PNP transistor Q7; and resistors R5 and R6.

When a current I1 of a certain value flows out from the input terminal 2, if the current I1 is smaller than a current I2 produced from the constant current source 6, a current (I2 - I1) representing a difference between these currents I1 and I2 is allowed to flow to the emitter of the transistor Q7 as the transistor Q7 becomes conductive and the transistor Q6 nonconductive. A voltage drop is then caused by the collector current of the transistor Q7 and the resistor R5. The voltage drop causes the base potential of the transistor Q8 to become higher than the forward voltage of the transistor Q8. The transistor Q8 becomes conductive to lower the level of the output of the output terminal 4.

In case that the current I1 is either equal to the current I2 or larger than the current I2, the transistor Q7 becomes nonconductive. The collector current of the transistor Q7 then becomes zero. Therefore, the level of the base voltage of the transistor Q8 becomes a ground level to make the transistor Q8 nonconductive. As a result, the output level of the output terminal 4 becomes high. Then, in the case of I1 = I2, the transistor Q6 is also nonconductive. However, in the event of I1 > I2, a difference current (I1 - I2) causes the transistor Q6 to become conductive and is supplied from the emitter of the transistor Q6.

In the case of this embodiment, as described above, the input current I1 is compared with the current I2 by the arrangement of the transistors Q6 and Q7, and the magnitude of the current I1 relative to the current I2 is determined by the on-or off-state of the transistor Q7.

In the case of the embodiment shown in Fig. 2, the input current is arranged to flow out from the input terminal 2. However, in a case where the input current is flowing in, the same advantageous effect is attainable by modifying the embodiment as shown in Fig. 3. The details of this modification are as follows:

Referring to Fig. 3, with a current $I1'$ of a certain value flowing to the input terminal 2, if the current $I1'$ is smaller than a current $I2'$ produced from a constant current source $6'$, a difference current $(I2' - I1')$ is supplied from the emitter of a transistor Q9 with the transistor Q9 becoming conductive and another transistor Q10 becoming nonconductive. Then, the collector current of the transistor Q9 and a resistor 7 cause a voltage drop. The voltage drop causes a voltage between the base and emitter of a transistor Q11 to become larger than the forward voltage of the transistor Q11. The transistor Q11 becomes conductive to cause the output level of the output terminal 4 to become high.

In case that the current $I1'$ is either equal to the current I2' or larger than the current $I2'$, the transistor Q9 becomes nonconductive. The collector current of the transistor Q9 becomes zero. Therefore, the base voltage of the transistor Q11 becomes equal to the voltage of power supply. The transistor Q11 becomes nonconductive and the output level of the output terminal 4 becomes low.

Then in the case of I1 = I2, the transistor Q10 is also nonconductive. In the event of $I1' > I2'$, the transistor Q10 becomes conductive to allow a difference current $(I1' - I2')$ to flow to its emitter.

As described in the foregoing, the embodiment is capable of detecting the magnitude of the input current relative to the current value set at the constant current source with a simple circuit arrangement without recourse to any arrangement of converting the input current into a voltage. In accordance with the invented arrangement, a current comparison circuit can be formed without the severe requirement for the absolute precision of the resistance value. The current comparison circuit according to this invention is, therefore, highly suited for the use of an IC.

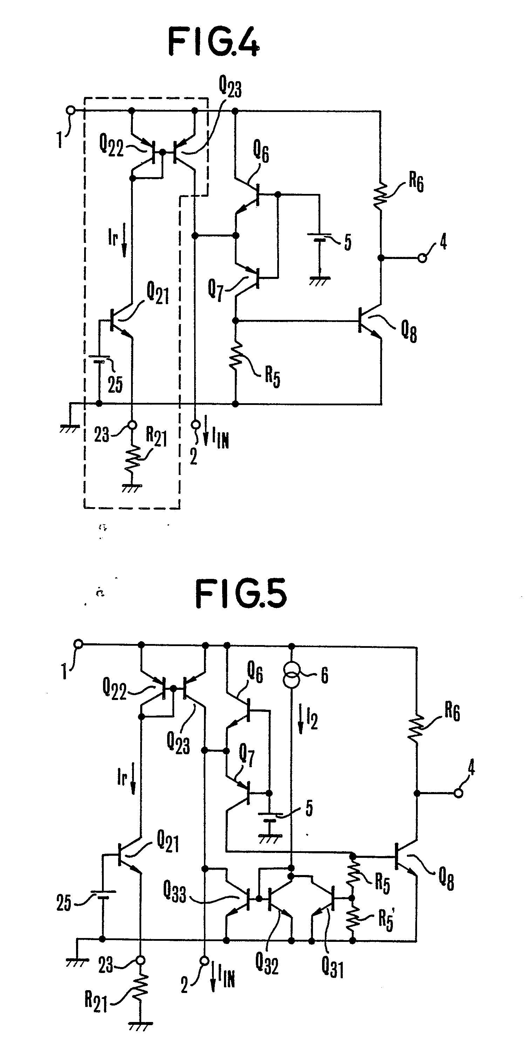

Fig. 4 shows in a circuit diagram another embodiment of this invention. In Fig. 4, the same components as those of the embodiment shown in Fig. 2 are indicated by the same reference numerals and symbols. The illustration includes a terminal 23 to which a resistor R21 for determining a reference current value is connected; a constant voltage source 25; an NPN transistor Q21; current mirror forming PNP transistors Q22 and Q23; and the resistor R21 which is connected to the above stated terminal 23. With the exception of the resistor R21, all these components are arranged in an IC. The resistor R21 is attached to the outside of the IC.

With the embodiment arranged as shown in Fig. 4 and with the constant voltage value of the constant voltage source 25 assumed to be V1, when a power supply voltage is applied to a power supply terminal 1, the following current flows to the collector of the transistor Q21:

$$\frac{V1 - VBE}{R21} = Ir$$

wherein VBE represents a voltage between the base and emitter of the transistor Q21, and R21 represents the resistance value of the resistor R21. The collector current of the transistor Q23 is about equal to the current Ir, because the transistors Q22 and Q23 form a current mirror and the base current portion thereof is ignorable. Therefore, the value of the current Ir becomes the reference current value of the current comparison circuit. In the case of $I_{IN}$ < Ir when a current $I_{IN}$ flows out from the input terminal 2, the transistor Q7 becomes conductive and the transistor Q6 nonconductive. As a result, a difference current $(Ir - I_{IN})$ comes to flow to the emitter of the transistor Q7. A voltage drop is caused by the collector current of the transistor Q7 and the resistor R5. The voltage drop then causes the base potential of the transistor Q8 to reach its forward voltage. The transistor Q8 becomes conductive and the output level of the output terminal 4 becomes low.

In the case of $I_{IN} \geqq I_r$, the transistor Q7 becomes nonconductive and its collector current becomes zero. The transistor Q8 therefore becomes nonconductive with its base voltage at the ground level. The output level of the output terminal 4 becomes high. Then, if the relation between the currents is $I_{IN} = I_r$, the transistor Q6 is also nonconductive. If the relation is $I_{IN} \geqq I_r$, the transistor Q6 becomes conductive to supply a difference current ($I_{IN} - I_r$) from its emitter.

In the case of the embodiment described, the reference current $I_r$ is determined by means of the resistor R21. The input current $I_{IN}$ which is flowing out is compared with the reference current $I_r$ by the arrangement of the transistors Q6 and Q7. The magnitude of the current $I_{IN}$ relative to the current $I_r$ is determined by the on-or off-state of the transistor Q8.

Further, a variable resistor may be employed as the resistor R21. As described in the foregoing, the embodiment employs as the reference current source a constant current circuit, which is arranged to permit setting a reference current value as desired by means of a resistor. This arrangement enables the current comparison circuit to have the reference current accurately set at a value suitable for any purpose. The use of the current setting resistor which is arranged to be an external component further enables the circuit to be advantageously formed by using an IC.

With the embodiment arranged as shown in Fig. 4, the comparison circuit tends to fail to instantaneously and sharply switch the state of the transistor Q8 from a conductive state over to a nonconductive state and vice versa in case that the input current $I_{IN}$ is nearly equal to the reference current $I_r$ and the transistor Q7 is within a transient range between conductive and nonconductive states. In such a case, the output terminal 4 might come to show a somewhat oscillatory state.

Fig. 5 shows a further embodiment of the invention which is an improvement over the comparison circuit of Fig. 4. In this case, a circuit is added to the circuit arrangement of Fig. 4 for the purpose of eliminating he above stated unstable switching which tends to take place in the proximity of the threshold value of the input current by imparting a hysteresis to the input-output characteristic of the comparison circuit. More specifically, the embodiment of Fig. 5 is provided with a circuit which is arranged to shunt a given amount of current from the input terminal when the input current value becomes close to the reference current value. By this arrangement, an offset is imparted to the input current to obtain a hysteresis characteristic which ensures a stable switching action.

In Fig. 5, the same components and parts as those of the circuit arrangement of Fig. 4 are indicated by the same reference numerals and symbols. The illustration includes a constant current source 6; and transistors Q31, Q32 and Q33. The transistors Q32 and Q33 form a current mirror. Resistors R5' and R5 are interconnected in series. A node between them is connected to the base of the transistor Q31. These circuit elements are arranged to form a circuit which imparts the above stated hysteresis characteristic to the comparison circuit.

The embodiment arranged as shown in Fig. 5 operates as follows: In case that the input current $I_{IN}$ is sufficiently smaller than the reference current $I_r$, a current ($I_r - I_{IN}$) representing a difference between these currents becomes the emitter current of the transistor Q7. The emitter current causes at voltage drop at the resistors R5 and R5' to bring the transistors Q8 and Q31 into a conductive state. As a result the level of the output from the output terminal 4 becomes low. Meanwhile, a current I2 which is supplied from the constant current source 6 flows to the transistor Q31. Then, the collector potential of the transistor Q31 becomes VCE(SAT) to bring the transistors Q32 and Q33 into a cut-off state.

When the value of the input current $I_{IN}$ becomes closer to the value of the reference current $I_r$, the collector current of the transistor Q7 decreases. Then, a voltage drop caused by collector current of the transistor Q7 and the resistor R5' causes the base potential of the transistor Q31 to become lower than the voltage VBE(ON) of the transistor Q31. This cuts off the transistor Q31. As a result, the current I2 from the constant current source 6 comes to flow to the collector of the transistor Q32 and the bases of the transistors Q32 and Q33. The transistors Q32 and Q33 become conductive. With their base currents not taken into consideration, the transistors Q32 and Q33 can be regarded as forming a current mirror. Therefore, a current which is almost the same as the current I2 flows to the collector of the transistor Q33. Hence, the instant the transistor Q32 turns on, the emitter current of the transistor Q7 decreases from the current ($I_r - I_{IN}$) to a current ($I_r - I_{IN} - I2$). At that instant, the base potential of the transistor Q8 becomes lower than the value VBE(ON) and the transistor Q8 is cut off. Then, the output level of the output terminal 4 becomes high.

In case that the input current $I_{IN}$ decreases from a larger value than the reference current $I_r$, the embodiment operates as follows: In this case, the transistor Q7 is in an off-state. Therefore, the transistor Q31 is also in an off-state. The current I2 is flowing to the collector of the transistor Q33. A current of a value ($I_{IN} + I2 - I_r$) is being supplied

from the emitter of the transistor Q6. With the input current $I_{IN}$ decreased, the current from the transistor Q6 further decreases. As a result, the transistor 6 is cut off, and a current of a value (Ir - $I_{IN}$ -I2) flows to the emitter of the transistor Q7. This causes a voltage drop at the resistor R5'. Then, the instant the base potential of the transistor Q31 comes to drop to the value VBE(ON), the collector potential of the transistor Q31 drops to the value VCE (SAT), so that the transistors Q32 and Q33 are cut off. This causes the collector current of the transistor Q7 to increase by the value of the current I2. As a result of this, the base potential of the transistor Q8 comes to exceed the value VBE(ON) to turn the transistor Q8 on. The level of the output voltage from the output terminal 4 then becomes low.

Assuming that the value of the collector current of the transistor Q7 necessary for turning the transistor Q31 on is I3, the threshold value of the input current $I_{IN}$ that is necessary for switching the output level of the output terminal 4 from a low level over to a high level can be expressed as (Ir - I3). Then, the threshold value for changing the output level from a high level to a low level can be expressed as (Ir - I2 - I3). The embodiment thus has a hysteresis corresponding to a difference I2 between these threshold values. This hysteresis enables the embodiment to have switching stably performed even at a point close to the threshold value.

In the case of the embodiment shown in Fig. 5, the provision of a circuit which is arranged to shunt the input current from the input terminal when the value of the input current becomes close to the reference current value gives a hysteresis characteristic to the comparison circuit as mentioned in the foregoing. The unstableness of switching which takes place when the value of the input current is close to the reference current value can be eliminated by virtue of this arrangement.

A current comparison circuit for comparing the value of an input current with a reference current value includes a constant current source which is arranged to produce a constant current of the reference current value and is connected to an input terminal to which the input current is allowed to flow, and a pair of PNP and NPN transistors which are arranged to have a constant voltage applied to their bases and to have their emitters interconnected. The emitters of the pair of PNP and NPN transistors are connected to a node between the input terminal and the constant current source.

## Claims

1. A current comparison circuit for detecting by comparison the magnitude of a current flowing at an input terminal thereof, comprising:

a) a first constant current source connected to said input terminal and arranged to produce a constant current of a given value;

b) a constant voltage circuit; and

c) a pair of NPN and PNP transistors having bases respectively connected to said constant voltage circuit, an emitter of said NPN transistor and an emitter of said PNP transistor being interconnected and said emitters being connected between said first constant current source and said input terminal.

2. A circuit according to claim 1, wherein a collector of said NPN transistor is connected to a power supply line, wherein said NPN transistor is connected in parallel to said first constant current source, and wherein a collector of said PNP transistor is grounded via a resistor, and said current comparison circuit further comprising a second NPN transistor having a base connected to a node between the collector of said PNP transistor and said resistor.

3. A circuit according to claim 1, wherein a collector of said PNP transistor is connected to a ground line, wherein said PNP transistor is connected in parallel to said first constant current source, and wherein a collector of said NPN transistor is connected to a power supply line via a resistor, and said current comparison circuit further comprising a second PNP transistor having a base connected to a node between the collector of said NPN transistor and said resistor.

4. A circuit according to claim 1, wherein said first constant current source includes a third transistor having a base to which a reference voltage is applied, one main electrode connected to a resistor and another main electrode connected to a pair of transistors forming a current mirror, and is arranged to produce a constant current corresponding to a resistance value of said resistor.

5. A circuit according to claim 4, wherein said third transistor is an NPN transistor having an emitter connected to said resistor.

6. A circuit according to claim 1, further comprising a fourth transistor having a base connected to a collector of one of said pair of NPN and PNP transistors, and a hysteresis circuit arranged to impart a hysteresis characteristic to said fourth transistor with respect to a current value flowing to said input terminal at the time of switching from an on-state over to an off-state and vice versa of said fourth transistor.

7. A circuit according to claim 6, wherein said hysteresis circuit includes a resistor connected to the collector of said one of transistors which has the collector connected to the base of said fourth transistor, a fifth transistor arranged to turn off when a voltage drop caused by said resistor reaches a voltage lower than a given value, a second constant current source arranged to supply a current to said fifth transistor when said fifth transistor is in an on-state, and a sixth transistor arranged to allow the current produced from said second constant current source to flow when said fifth transistor is in an off-state, one of main electrodes of said sixth transistor being connected to a node between said input terminal and said first constant current source.

8. A current comparison circuit for detecting by comparison the magnitude of a current flowing at an input terminal, comprising:

a) a first constant current source connected to said input terminal and arranged to produce a constant current of a given value;

b) a first transistor arranged to cause the flow of a current corresponding to a difference between the value of said constant current from said first constant current source and the current flowing at said input terminal;

c) a resistor for causing a voltage drop through the current flowing at said first transistor;

d) a second transistor which inverts the output state thereof from one state over to another according to whether the degree of the voltage drop caused by said resistor is above a given value or below said given value and is thus arranged to produce an output corresponding to the magnitude of the current flowing to said input terminal;

e) a second constant current source; and

f) a third transistor arranged to turn on or off according to whether or not the degree of the voltage drop caused by said resistor is above a given value which differs from the output inverting level of said second transistor, said third transistor being arranged such that, when it is on, a current from said second constant source is allowed flow and has one of main electrodes connected between said input terminal and said first constant current source.

9. A circuit according to claim 8, wherein the inverting level of said third transistor is lower than the inverting level of said second transistor.

# FIG.1

# FIG.2

# FIG.3

# FIG.4

# FIG.5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,Y | US-A-4 689 499 (YEE)<br>* Column 4, lines 48-68; figures 1-2 * | 1 | G 01 R 19/165 |
| A | | 2-3,8 | |
| Y | EP-A-0 190 471 (N.V. PHILIPS' GLOEILAMPENFABRIEKEN)<br>* Page 4, lines 25-31; figure 1 * | 1 | |
| A | | 3,8 | |
| A | DE-A-2 800 435 (ROBERT BOSCH)<br>* Page 4, lines 9-20; figure * | 1,8 | |
| A | US-A- 957 008 (SHENG)<br>* Abstract; figures 1-2 * | 4 | |
| A | GB-A-2 062 996 (ROBERT BOSCH)<br>* Page 1, line 101 - page 2, line 8; figures 1-2,5 * | 6-7 | |
| A | EP-A-0 189 894 (OMRON TATEISI ELECTRONICS CO.)<br>* Page 16, line 12 - page 20, line 20; figures 3,4B,23,41,42 * | 1 | TECHNICAL FIELDS SEARCHED (Int. Cl.4)<br><br>G 01 R 19/00<br>H 03 K 17/00<br>H 03 K 3/00 |

The present search report has been drawn up for all claims

| Place of search | Date of completion of the search | Examiner |
|---|---|---|
| THE HAGUE | 27-07-1988 | TRELEVEN C. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...........................................................................
& : member of the same patent family, corresponding
   document

EPO FORM 1503 03.82 (P0401)